# EUROPÄISCHE PATENTANMELDUNG

(11) **EP 4 203 640 A1**
(43) Veröffentlichungstag der Anmeldung: **28.06.2023**
(21) Anmeldenummer: 21216754.8
(22) Anmeldetag: 22.12.2021
(51) Int. Cl.: H05K 13/08, B23K 1/008

(54) **BETREIBEN EINER ELEKTRONIKFERTIGUNGSLINIE**

(71) Anmelder: Siemens Aktiengesellschaft, 80333 München (DE)
(72) Erfinder: Borwieck, Carsten, 14052 Berlin (DE); Erdmann, Michael, 14822 Borkheide (DE); Hanisch, Michael, 16540 Hohen Neuendorf (DE); Jarchoff, Kay, 13347 Berlin (DE); Müller, Bernd, 16259 Falkenberg (DE); Wittreich, Ulrich, 16727 Velten (DE)
(74) Vertreter: Siemens Patent Attorneys

(57) **Zusammenfassung**

Die Erfindung betrifft ein Verfahren zum Betreiben einer Elektronikfertigungslinie (200) zum Herstellen von elektronischen Baugruppen (100), wobei die Elektronikfertigungslinie (200) zumindest
- eine Vorrichtung (20) zum Aufbringen von Fügematerial auf ein oder mehrere Bauelementträger (PCB),
- eine Bestückvorrichtung (30) zum Bestücken von elektronischen Bauelementen auf die Bauelementträger (PCB),
- eine Fügevorrichtung (40) zum Fügen der elektronischen Bauelemente an die Bauelementträger (PCB) und
- ein Transportsystem (250), das zum Transportieren der Bauelementträger (PCB) durch die Vorrichtungen (20, 30, 40) ausgebildet ist, aufweist. Um die Einhaltung von Prozessvorgaben auf Produktniveau sicherzustellen umfasst das Verfahren die Schritte:
- Bereitstellen von Ist-Prozessparameterwerten (ACT1, ACT2), umfassend zumindest einen Parameterwert, der in einem begrenzten Bereich (h) um das Transportsystem (250) erfasst wird,
- Bereitstellen von Soll-Prozessparameterwerten (SET),
- Ermitteln von Abweichungen (DEV) zwischen Ist- und Soll-Prozessparameterwerten (SET, ACT1, ACT2),
- Ausgeben eines Datensatzes (D) der zumindest die Abweichungen (DEV) umfasst.

Die Erfindung betrifft weiterhin eine Elektronikfertigungslinie (200), ein Prozessparametererfassungssystem (AIO) und ein System.

## Beschreibung

Die Erfindung betrifft ein Verfahren zum Betreiben einer Elektronikfertigungslinie, eine Elektronikfertigungslinie, ein Prozessparametererfassungssystem und ein System.

Ein derartiges Verfahren und derartige Elektronikfertigungslinien kommen beispielsweise in Fertigungen für Industrieelektronik, Leistungselektronik und Mikroelektronik zum Einsatz.

Elektronikfertigungslinien weisen Vorrichtungen zum Durchführen einzelner Fertigungsschritte auf. Diese Vorrichtungen weisen üblicherweise Sensoren auf, die zum Erfassen der jeweiligen vorrichtungsspezifischen Parameterwerte ausgebildet sind, bspw. Temperaturen und Restsauerstoffgehalt in einem Reflow-Ofen. Bestückautomaten, Schablonendrucker und Reflow-Öfen können jeweils Parameterwerte innerhalb der eigenen Vorrichtung erfassen. Um eine dauerhafte Einhaltung von geforderten Prozessbedingungen garantieren zu können ist neben einer Regelung (closed-loop) und/oder einer Steuerung (openloop) in den einzelnen Vorrichtungen ein regelmäßiger Abgleich der tatsächlich auf Produktniveau auftretenden Istwerte mit den Soll-Prozessparametern für das jeweilige Produkt von Vorteil.

Der Nachweis der Einhaltung der geforderten Prozessbedingungen für ein definiertes Produkt, z. B. eine elektronische Baugruppe, ist hinsichtlich einer garantierten Qualität gerade bei Großserien und im laufenden Betrieb von enormer Bedeutung.

Der Erfindung liegt die Aufgabe zugrunde, die Einhaltung von Prozessvorgaben auf Produktniveau sicherzustellen.

Diese Aufgabe wird durch ein Verfahren zum Betreiben einer Elektronikfertigungslinie zum Herstellen von elektronischen Baugruppen mit den im Anspruch 1 angegebenen Merkmalen gelöst. Die Elektronikfertigungslinie weist dabei zumindest eine Vorrichtung zum Aufbringen von Fügematerial auf ein oder mehrere Bauelementträger, eine Bestückvorrichtung zum Bestücken von elektronischen Bauelementen auf die Bauelementträger, eine Fügevorrichtung zum Fügen der elektronischen Bauelemente an die Bauelementträger und ein Transportsystem, das zum Transportieren der Bauelementträger durch die Vorrichtungen ausgebildet ist, auf. Das Verfahren umfasst dabei die Schritte:
- Bereitstellen von Ist-Prozessparameterwerten umfassend zumindest einen Parameterwert, der in einem Bereich um das Transportsystem erfasst wird,
- Bereitstellen von Soll-Prozessparameterwerten,
- Ermitteln von Differenzen zwischen Ist- und Soll-Prozessparameterwerten und
- Ausgeben eines Datensatzes der zumindest die Abweichungen umfasst.

Ist-Prozessparameterwerte sind dabei die tatsächlichen Parameterwerte, die in oder im Umfeld der Elektronikfertigungslinie z.B. von Sensoren oder Zählern erfasst werden. Dazu zählen unter anderem Temperaturen, Restsauerstoffkonzentrationen, Beschleunigungen, Taktung der Linie, Auftretende Kräfte, und weitere Parameter.

Als Bauelementträger kommen jegliche Leiterplatten, die mit einem Transportsystem durch die Fertigungslinie transportiert werden können, also z.B.: PCBs, DCBs, ... in Frage. Die Bauelemente sind SMD oder THD Bauelemente. Es können ungehäuste Chips (sogenannte bare dies) als Bauelemente verarbeitet werden.

Der Bereich ist dabei ein begrenzter Bereich um das Transportsystem, in anderen Worten ein Bereich, der regelmäßig durch die Baugruppen bzw. durch die darauf angeordneten Bauelemente durchlaufen wird und in dem die für den tatsächlichen Prozess maßgeblichen Bedingungen vorherrschen. Eine Erfassung von Prozessparametern im Bereich lässt dabei unmittelbare Rückschlüsse auf die Bedingungen zu, die tatsächlich auf die Baugruppen (ein)wirken.

Die Soll-Prozessparameterwerte sind dabei die Parameterwerte, die während der Fertigung der elektronischen Baugruppen auf die elektronischen Baugruppen bzw. die Bauelementträger einwirken sollen. Die Einhaltung der Soll-Prozessparameterwerte wird in jeder der Vorrichtungen durch eine Steuerung und/oder durch eine Regelung sichergestellt. Beim Ermitteln der Abweichungen zwischen Ist- und Soll-Prozessparameterwerten wird also überprüft, ob die Vorrichtungen selbst noch in der Lage sind die Soll-Prozessparameterwerte einzuhalten. Eine Regelung oder eine Steuerung innerhalb einer Vorrichtung würde eine solche Abweichung nicht erkennen können, da diese ja nur ihre eigenen Messwerte zur Verfügung hat. Auch kann sein, dass eine Regelung in der Vorrichtung selbst zu tolerant gegenüber wegdriftenden Werten ist. Im erfindungsgemäßen Datensatz können schlussendlich die Abweichungen dokumentiert und für weitere Zwecke verwendet werden.

In einer weiteren Ausführungsform wird der Bereich zumindest teilweise von den Bauelementträgern durchlaufen. Die Bauelementträger können dabei bereits im bestückten Zustand, im mit Fügematerial versehenen Zustand oder bereits im ungefügten komplett bestückten Zustand den Bereich durchlaufen. Es ist denkbar, dass während oder nach eines Fügeprozesses auch bereits fertig gefügte elektronische Baugruppen bzw. deren Bauelementträger mit den elektronischen Bauelementen den Bereich durchlaufen. Der Bereich ist dabei so angeordnet, dass keine weiteren Sensoren dauerhaft angeordnet werden können, da im gesamten Bereich die Möglichkeit besteht, dass eine Baugruppe durchführt und somit mit einem fest angeordneten Sensor kollidieren würde.

In einer weiteren Ausführungsform erstreckt sich der Bereich von maximal 40 mm oberhalb einer Transportebene des Transportsystems bis maximal 30 mm unterhalb der Transportebene des Transportsystems. Insbesondere haben sich Werte von 35 mm oberhalb der Transportebene und 25 mm unterhalb der Transportebene als vorteilhaft erwiesen. Die Transportebene ist dabei die Ebene, die sich dadurch definiert, dass die Bauelementträger auf dem Transportsystem aufliegen und somit die Auflagefläche einen Nullpunkt bzw. die Transportebene definiert.

In einer weiteren Ausführungsform umfassen die Ist-Parameterwerte zumindest einen Messwert, der von einer der Vorrichtungen bereitgestellt wird. So umfassen die Ist-Parameterwerte nicht nur Ist-Werte im Bereich um das Transportsystem, sondern auch Parameterwerte, die durch die Sensoren der Vorrichtungen außerhalb des Bereiches bereitgestellt werden. Dies ermöglicht das Erstellen eines vollständigeren Datensatz, eine genauere Ermittlung der Abweichungen und vor allem wird der Kontext für die Messwerte im Bereich zur Verfügung gestellt.

In einer weiteren Ausführungsform umfasst das Verfahren die Schritte Ausgeben einer Warnmeldung, wenn die Abweichungen einen jeweiligen Schwellwert überschreiten und/oder Ausgeben eines Konformitätsdatensatzes, wenn die Abweichungen einen jeweiligen Schwellwert unterschreiten. Wenn die Abweichungen einen Schwellwert überschreiten, so muss dies nicht zwangsläufig zu einem sofortigen Stopp der Fertigungslinie führen, sondern es kann sich durch das vorgesehene Verfahren eine entsprechende Wartungsnotwendigkeit oder ein Nachstellen einiger Parameter andeuten.

Ein Konformitätsdatensatz bestätigt, dass die Prozessparameterwerte während der Produktion der Baugruppen den geforderten maximalen Abweichungen entsprochen haben. Ein solcher Konformitätsdatensatz kann mit einer gewissen Anzahl von Seriennummern von Baugruppen verknüpft und optional kryptografisch als Zertifikat für die definierte Anzahl von Seriennummern ausgegeben werden.

In einer weiteren Ausführungsform umfassen die Ist-Prozessparameterwerte zumindest eine Restsauerstoffkonzentration im Bereich und/oder eine Temperatur im Bereich. Die Ist-Prozessparameterwerte können dabei an mehreren Stellen im Bereich entlang des Transportsystems erfasst werden, sodass sich ein Parameterwertverlauf ergibt. Grundlegend ist aber ausreichend an besonders wichtigen Stellen eine Restsauerstoffkonzentration und eine Temperatur im Bereich zu erfassen. Es hat sich herausgestellt, dass die Restsauerstoffkonzentration und die Temperatur auf Bauelementträgerniveau ein sehr guter Indikator für eine Güte der Fertigung sind. Treten im Bereich Abweichungen von den Sollwerten auf, so können diese Abweichungen auf eine Wartungsbedürftigkeit der Anlage, eine Notwendigkeit des Kalibrierens bestimmter Sensoren der Anlage oder anderweitige Defekte in der Anlage hinweisen.

In einer weiteren vorteilhaften Ausführungsform werden die Ist-Prozessparameter im Bereich zumindest teilweise durch ein Prozessparametererfassungssystem erfasst, das zum Durchlaufen der Elektronikfertigungslinie auf dem Transportsystem ausgebildet ist. Der große Vorteil der Erfassung von Ist-Prozessparameterwerten mit einem derartigen Prozessparametererfassungssystem liegt in der Aussagefähigkeit der erfassten Messwerte für die tatsächlichen Prozessbedingungen, wie sie auf die elektronischen Baugruppen bzw. die Bauelementträger einwirken.

In einer weiteren Ausführungsform werden die Ist-Prozessparameterwerte und/oder die Abweichungen jeweils für eine definierbare Anzahl von Baugruppen vor und/oder nach deren Herstellung erfasst. Für die Anzahl an Baugruppen, die unter gleichen Bedingungen gefertigt werden sollen, kann jeweils regelmäßig die Ist-Prozessparameter erfasst werden, um sicherzustellen, dass die gleichen Bedingungen auch für alle gefertigten Baugruppen gegolten haben. So kann beispielsweise alle 10, 20, 50 oder alle 100 Baugruppen ein Satz Ist-Prozessparameter erfasst und dokumentiert werden.

In einer weiteren Ausführungsform umfasst das Verfahren den Schritt Ausgeben eines Kalibrierdatensatzes auf, wenn die Abweichungen einen jeweiligen Schwellwert überschreiten. Wenn Messwerte der Sensoren der Vorrichtungen gleichbleibende oder sich nicht im selben Maße verändernde Werte, wie die im Bereich erfassten Messwerte aufweisen, so ist davon auszugehen, dass eine Kalibrierung oder eine Offsetkorrektur der Sensorik in den Vorrichtungen durchgeführt werden sollte. Ein solcher Kalibrierdatensatz kann als ein erster Hinweis dienen. Wird ein kalibriertes Prozessparametererfassungssystem verwendet, so kann zumindest eine erste Kalibrierung automatisiert von der Elektronikfertigungslinie selbst durchgeführt werden, indem entsprechende Offset-Werte automatisiert eingestellt werden. Dies kann den Zeitraum zwischen einer laborbasierten und den Ausbau des Sensors erfordernden Kalibrierung verlängern und somit eine Fertigung ermöglichen, die über lange Zeit gleichbleibende Qualitätsstandards einhält.

Ergänzend oder alternativ können die Kalibrierdaten zumindest eine Restsauerstoffkonzentration und eine Temperatur umfassen, die jeweils im Bereich erfasst wurden.

In einer weiteren Ausführungsform wird jeder der hergestellten Baugruppen ein Konformitätsdatensatz zugeordnet, der die Abweichungen im Bereich enthält. So kann für jede Baugruppe nachvollzogen werden, ob es auf Baugruppenniveau Abweichungen gab und wie groß diese waren. Diese Daten können beispielsweise für eine Selektion von besonders hochwertigen Baugruppen für besonders hochbeanspruchte Anwendungen dienen.

In einer weiteren Ausführungsform fordert die Elektronikfertigungslinie und/oder eine übergeordnete Fertigungssteuerung nach einer definierbaren Anzahl an gefertigten Baugruppen ein Prozessparametererfassungssystem an. So kann vollständig automatisiert eine Erfassung der relevanten Parameter stattfinden und der erfindungsgemäße Datensatz erstellt werden. Ergänzend oder alternativ kann sich das Prozessparametererfassungssystem selbsttätig an der Elektronikfertigungslinie anmelden, um eine Kontrolle durchzuführen. Die Elektronikfertigungslinie kann dann alle Prozessparameter aufrechterhalten aber beispielsweise eine Testbestückung ohne Bauelemente für eine Kraftmessung durchführen. Es hat sich als vorteilhaft herausgestellt, wenn die Erfassungseinrichtung direkt im Anschluss an oder zwischen einer definierbaren Anzahl an Baugruppen durch die Elektronikfertigungslinie fährt, da so die thermischen Massen in der Linie und die dort auftretenden Prozesskräfte und Beschleunigungen am realistischsten sind.

Die Aufgabe wird weiterhin durch ein Verfahren zum automatisierten Kalibrieren einer Elektronikfertigungslinie gelöst. Die Elektronikfertigungslinie wird dabei nach einem Verfahren gemäß einer der vorhergehenden Ausführungsformen betrieben. Ein Offset kann weiterhin eingestellt werden, um eine Kalibrierung in zumindest einer der Vorrichtungen auf Basis der Abweichungen im Datensatz durchzuführen.

Die Aufgabe wird weiterhin durch eine Elektronikfertigungslinie gelöst, die zum Durchführen eines Verfahrens gemäß einer der obigen Ausführungsformen ausgebildet ist. Die Elektronikfertigungslinie weist dabei Vorrichtungen zum Aufbringen von Fügematerial auf Bauelementträgern, zum Bestücken von elektronischen Bauelementen auf die Bauelementträger und zum Fügen der elektronische Bauelemente an die Bauelementträger auf. Ein Transportsystem ist dabei zum Transportieren der Bauelementträger durch die Vorrichtungen ausgebildet und vorgesehen. Weiterhin weist die Elektronikfertigungslinie eine Auswerteeinrichtung auf, die zum Ermitteln von Abweichungen zwischen Ist- und Soll-Prozessparameterwerten ausgebildet ist. Die Auswerteeinrichtung kann dabei weiterhin eine Kommunikationsschnittstelle aufweisen, die zum Kommunizieren mit einem Prozessparametererfassungssystem ausgebildet ist, das zum Durchlaufen der Elektronikfertigungslinie auf dem Transportsystem ausgebildet ist. Die Kommunikationsschnittstelle kann dabei auch ein Anmelden des Erfassungssystems an den einzelnen Vorrichtungen übernehmen, dass beispielsweise ein Bestückautomat keine Bestückung vornimmt oder nur eine Leerbestückung ohne Bauteile um eine Kraftmessung durchzuführen, vorgesehen wird.

Im Folgenden wird die Erfindung anhand der in den Figuren dargestellten Ausführungsbeispiele näher beschrieben und erläutert. Es zeigen:
- FIG 1: schematisch eine Elektronikfertigungslinie,
- FIG 2: einen schematischen Querschnitt durch ein Transportsystem,
- FIG 3: schematisch ein Prozessparametererfassungssystem auf einem Transportsystem,
- FIG 4: schematisch eine Fügevorrichtung und
- FIG 5: eine schematische Darstellung des Datenflusses innerhalb der Elektronikfertigungslinie.

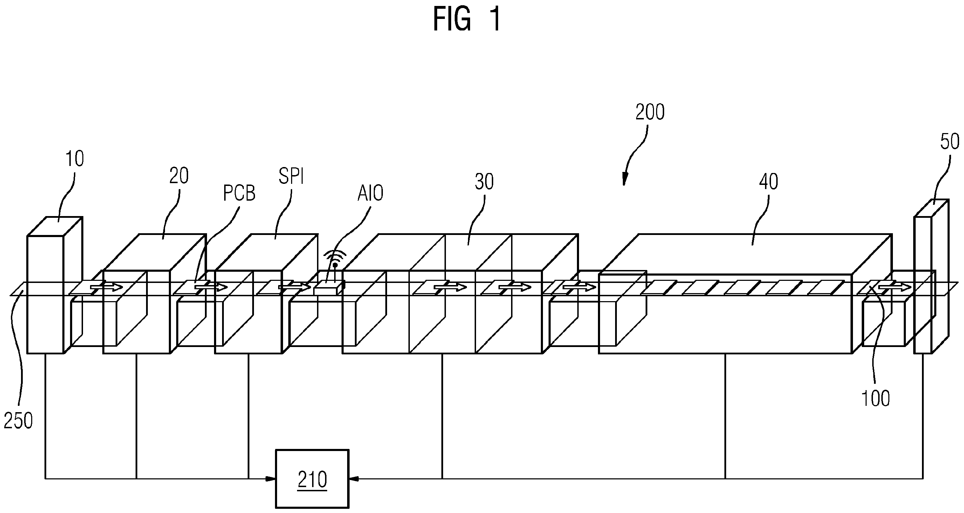

FIG 1 zeigt schematisch eine Elektronikfertigungslinie 200 mit ihren einzelnen Vorrichtungen 10,...,50, die über ein Transportsystem 250 miteinander verbunden sind. Eine Bereitstellungsvorrichtung 10 stellt Bauelementträger PCB bereit, die dann über das Transportsystem 250 in eine Vorrichtung 20 zum Aufbringen von Fügematerial einfahren. Daraufhin ist eine Inspektionsvorrichtung SPI gezeigt, die im vorliegenden Fall eine Solder-Paste-Inspection sein kann und Qualitätsdaten hinsichtlich eines Fügematerialauftrags liefert. Im Anschluss daran ist eine Bestückvorrichtung 30 gezeigt, die die mit Fügematerial versehene Bauelementträger PCB mit elektronischen Bauelementen bestückt. Eine Fügevorrichtung 40, z. B. ein Reflow-Ofen, fügt nun die elektronischen Bauelemente an den Bauelementträger PCB durch Aufschmelzen oder Sintern eines Fügematerials. Mit dem Fügevorgang entstehen auch die elektronischen Baugruppen 100, die dann in einer Sammelvorrichtung 50 gesammelt werden können. Weiterhin zu sehen ist ein Prozessparametererfassungssystem AIO, das zum Durchfahren der Elektronikfertigungslinie 200 auf dem Transportsystem 250 ausgebildet ist. Das Erfassungssystem AIO ist also so ausgestaltet, dass es wie die Bauelementträger PCB mit dem Transportsystem 250 transportiert werden kann. Die Elektronikfertigungslinie 200 kann dabei um für die Baugruppen 100 notwendige Vorrichtungen 10,...,50 erweitert werden. So ist es möglich, mehrere Bestückautomaten 30 oder mehrere Inspektionsvorrichtungen in einer Linie 200 vorzusehen.

Eine Auswerteeinrichtung 210 steht in Kommunikationsverbindung mit den Vorrichtungen 10,...,50. Dabei ist im vorliegenden Fall eine direkte Kommunikationsverbindung zu den einzelnen Vorrichtungen 10,...,50 vorhanden. Ebenso ist möglich, dass eine einzelne der Vorrichtungen 10,...,50 die Daten aller anderen sammelt oder eine über jeweilige andere Vorrichtungen 10,...,50 gehende Kommunikationsverbindung vorhanden ist, sodass nicht jede einzelne der Vorrichtungen 10,...,50 verbunden sein muss.

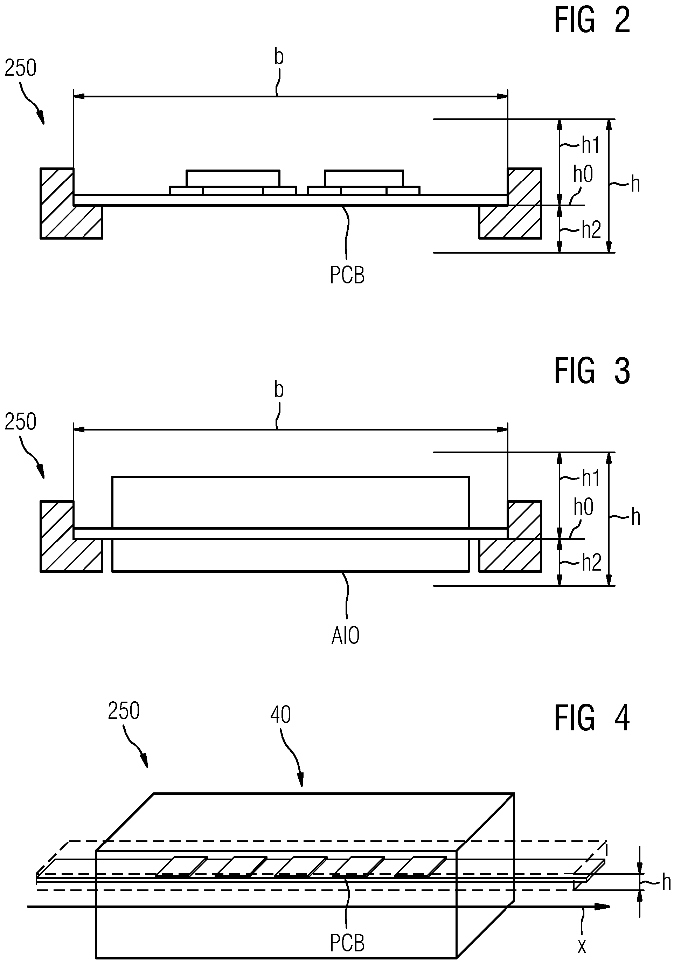

FIG 2 zeigt einen schematischen Querschnitt durch das in FIG 1 gezeigte Transportsystem 250. In Elektronikfertigungslinien ist oft ein kettenbasiertes Transportsystem vorhanden, das die Bauelementträger PCB z. B. mit einer Klemmung durch die Elektronikfertigungslinie 200 transportiert. Das Transportsystem 250 ist dabei in der Lage in der Breite b verstellt zu werden, sodass die unterschiedlichen Bauelementträger PCB sicher transportiert werden können. Weiterhin zu sehen ist eine Transportebene h0, die sich aus der Auflage des Transportsystems 250 ergibt, auf der die Bauelementträger PCB aufliegen.

Ein Bereich h um die Transportebene herum ist ebenso definiert wie ein Bereich h1 oberhalb der Transportebene h0 sowie ein Bereich h2 unterhalb der Transportebene h0. Für den Bereich h1 oberhalb des Transportsystems 250 haben sich Werte von maximal 35 mm und für den Bereich h2 unterhalb von maximal 25 mm als vorteilhaft erwiesen, da diese in gängigen Elektronikfertigungslinien und mit gängigen bestückten Bauelementträgern eingehalten werden. So kann davon ausgegangen werden, dass wenn ein Messwert im Bereich h erfasst wird, dass dieser maßgeblich die Bedingungen bzw. die Prozessparameter darstellt, wie sie tatsächlich auf einen Bauelementträger PCB einwirken. Der Bereich h ist dabei in seiner breite auf die maximal durch das Transportsystem 250 bereitstellbare Transportbreite b begrenzt. Beste Messwerte ergeben sich innerhalb des Bereiches h, an den Orten, wo im Durchschnitt die meisten Bauteile passieren. Dies kann zum Beispiel bezüglich der Breite b mittig und von 1 bis 5mm oberhalb der Transportebene h0 sein. Ebenso können mehrere Messpunkte über die Breite b verteilt sein.

FIG 3 zeigt schematisch ein Prozessparametererfassungssystem AIO, das auf dem Transportsystem 250 transportiert wird. Der Bereich h und die Breite b ist analog zu FIG 2 angegeben. Zu sehen ist auch, dass das Prozessparametererfassungssystem AIO nicht zwangsläufig den kompletten Bereich h ausfüllen muss. Wenn das Prozessparametererfassungssystem AIO den Bereich h durchfährt, so kann ein Prozessparameterwert-Profil erstellt werden, indem an mehreren Punkten oder (quasi-)kontinuierlich z. B. mit einer geeigneten Abtastfrequenz erfasst wird.

FIG 4 zeigt schematisch eine Fügevorrichtung 40, mit einem Ausschnitt des Transportsystems 250 und einer graphischen Darstellung wie sich der Bereich h entlang der Bewegungsrichtung x durch die Fügevorrichtung 40 erstreckt. Der Bereich h bildet so einen virtuellen Tunnel um das Transportsystem, in dem die Prozessparameterwerte den Sollwerten entsprechen müssen. Der Bereich h ist dabei immer innerhalb der jeweiligen Vorrichtung 10,...,50 außer in Abschnitten des Transportsystems 250, die zwischen, vor oder nach den jeweiligen Vorrichtungen angeordnet sind.

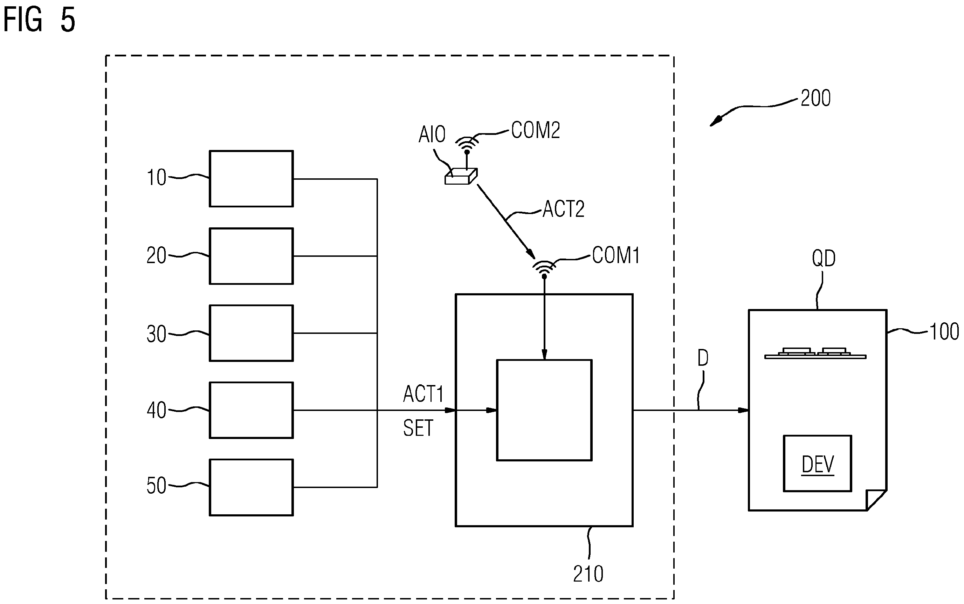

FIG 5 zeigt eine schematische Darstellung des Datenflusses innerhalb einer Elektronikfertigungslinie 200. Dabei ist die Auswerteeinrichtung 210 ein zentrales Element. Die Vorrichtungen 10,...,50 stellen erste Ist-Prozessparameterwerte ACT1 bereit. Die ersten Ist-Prozessparameterwerte ACT1 sind dabei Parameterwerte, die direkt von den Vorrichtungen 10,...,50 erfasst und ausgegeben werden (z. B. Temperaturen außerhalb des Bereichs h aber innerhalb der Vorrichtung 10,...,50, Kräfte, Beschleunigungen, Taktzeiten, ...).

Die Auswerteeinrichtung 210 weist weiterhin eine erste Kommunikationsschnittstelle COM1 auf, die zur Kommunikation mit einer zweiten Kommunikationsschnittstelle COM2 eines Prozessparametererfassungssystems AIO ausgebildet ist. Das Prozessparametererfassungssystem AIO ist dabei zum Durchlaufen der Elektronikfertigungslinie 200 auf einem Transportsystem 250, das hier nicht gezeigt ist, ausgebildet. Die Kommunikationsschnittstellen COM1, COM2 können dabei so ausgebildet, dass eine Kommunikation während des Durchlaufs ermöglicht wird. Alternativ oder ergänzend kann das Prozessparametererfassungssystem AIO auch einen internen Speicher für die erfassten Daten aufweisen, die dann direkt nach dem Durchlauf an die Auswerteeinrichtung 210 übermittelt werden, um eine Verknüpfung mit dem laufenden Produktionsprozess zu ermöglichen.

Das Prozessparametererfassungssystem AIO liefert dabei zweite Ist-Prozessparameterwerte ACT2, die im Bereich h erfasst werden und damit die tatsächlich auf die Bauelementträger PCB einwirkenden Parameterwerte widerspiegeln. Die Auswerteeinrichtung 210 kann dabei aus den ersten und den zweiten Ist-Prozessparameterwerten ACT1, ACT2 sowie hier gezeigten Soll-Prozessparameterwerten SET für die jeweiligen Vorrichtungen 10,...,50 eine Abweichung DEV bestimmen. Diese Abweichung DEV, eine Auswahl oder alle Soll-Prozessparameter SET, eine Auswahl oder alle Ist-Prozessparameter ACT1, ACT2 können dann in einem Datensatz D hinterlegt werden. Die Abweichung DEV kann dabei eine Differenz sein, es können aber ebenso entsprechende mathematische Analysen durchgeführt werden, die Tendenzen oder Trends in Wertverläufen darstellen.

Das Prozessparametererfassungssystem AIO kann in der laufenden Produktion (z. B. Chargenweise oder nach einer festgelegten Anzahl an Baugruppen) automatisiert die Elektronikfertigungslinie 200 durchlaufen. Es kann sich dazu in der Anlage anmelden oder von einer zentralen Auswerteeinrichtung 210 angemeldet und angefordert werden, durchläuft die Linie 200 und führt entsprechende Messungen für Prozessparameterwerte ACT2 im Bereich h durch. Direkt im Abschluss an das Prozessparametererfassungssystem AIO können weitere Baugruppen gefertigt werden.

In einem weiteren Schritt kann der Datensatz D in einen Konformitätsdatensatz QD umgewandelt werden, der für eine definierte Anzahl an elektronischen Baugruppen 100 die Konformität der Prozessparameterwerte bestätigt. Wenn die Abweichungen nicht mehr den Spezifikationen entsprechen, z. B. eine bestimmte Schwelle überschreiten, so kann eine Warnmeldung ausgegeben werden, die die Abweichungen dokumentiert. Daraufhin können dementsprechende Schritte eingeleitet werden. Die Schritte kann dabei von einer Fehlersuche, z. B. eine Undichtigkeit oder ein Defekt eines Sensors oder eines Heizelements reichen. Es ist möglich, die Abweichungen über einen längeren Zeitraum zu betrachten, z. B. über den Vergleich mehrerer Konformitätsdatensätze. Wenn ein Drift der Abweichungen DEV festgestellt wird, kann ein Off-Set-Wert zur Kalibrierung von Sensoren der Vorrichtungen 10,...,50 eingestellt werden. Sollte diese Korrektur nicht von Erfolg sein, so kann eine Kalibrierung der Sensoren im Labor der Vorrichtungen 10,...,50 angezeigt sein.

Zusammenfassend betrifft die Erfindung ein Verfahren zum Betreiben einer Elektronikfertigungslinie 200 zum Herstellen von elektronischen Baugruppen 100, wobei die Elektronikfertigungslinie 200 zumindest
- eine Vorrichtung 20 zum Aufbringen von Fügematerial auf ein oder mehrere Bauelementträger PCB,
- eine Bestückvorrichtung 30 zum Bestücken von elektronischen Bauelementen auf die Bauelementträger PCB,
- eine Fügevorrichtung 40 zum Fügen der elektronischen Bauelemente an die Bauelementträger PCB und
- ein Transportsystem 250, das zum Transportieren der Bauelementträger PCB durch die Vorrichtungen 20, 30, 40 ausgebildet ist, aufweist. Um die Einhaltung von Prozessvorgaben auf Produktniveau sicherzustellen umfasst das Verfahren die Schritte:
- Bereitstellen von Ist-Prozessparameterwerten ACT1, ACT2, umfassend zumindest einen Parameterwert, der in einem begrenzten Bereich h um das Transportsystem 250 erfasst wird,
- Bereitstellen von Soll-Prozessparameterwerten SET,
- Ermitteln von Abweichungen DEV zwischen Ist- und Soll-Prozessparameterwerten SET, ACT1, ACT2,
- Ausgeben eines Datensatzes D der zumindest die Abweichungen DEV umfasst.

Die Erfindung betrifft weiterhin eine Elektronikfertigungslinie 200, ein Prozessparametererfassungssystem AIO und ein System.

### Bezugszeichen

- 100: elektronische Baugruppen
- PCB: Bauelementträger
- 200: Elektronikfertigungslinie
- 210: Auswerteeinrichtung

- 10: Bereitstellungsvorrichtung
- 20: Vorrichtung zum Aufbringen von Fügematerial
- 30: Bestückvorrichtung
- 40: Fügevorrichtung
- 50: Sammelvorrichtung

- 250: Transportsystem
- h0: Transportebene
- h: Bereich
- h1, h2: Bereich ober/unterhalb der Transportebene

- SPI: Inspektionsvorrichtung
- SET: Soll-Prozessparameterwerte
- ACT1, ACT2: Ist-Prozessparameterwerte
- DEV: Abweichungen
- D: Datensatz
- QD: Konformitätsdaten

## Patentansprüche

1. Verfahren zum Betreiben einer Elektronikfertigungslinie (200) zum Herstellen von elektronischen Baugruppen (100), wobei die Elektronikfertigungslinie (200) zumindest
- eine Vorrichtung (20) zum Aufbringen von Fügematerial auf ein oder mehrere Bauelementträger (PCB),
- eine Bestückvorrichtung (30) zum Bestücken von elektronischen Bauelementen auf die Bauelementträger (PCB),
- eine Fügevorrichtung (40) zum Fügen der elektronischen Bauelemente an die Bauelementträger (PCB) und
- ein Transportsystem (250), das zum Transportieren der Bauelementträger (PCB) durch die Vorrichtungen (20, 30, 40) ausgebildet ist, aufweist,
umfassend die Schritte:
- Bereitstellen von Ist-Prozessparameterwerten (ACT1, ACT2), umfassend zumindest einen Parameterwert, der in einem begrenzten Bereich (h) um das Transportsystem (250) erfasst wird,
- Bereitstellen von Soll-Prozessparameterwerten (SET),
- Ermitteln von Abweichungen (DEV) zwischen Ist- und Soll-Prozessparameterwerten (SET, ACT1, ACT2),
- Ausgeben eines Datensatzes (D) der zumindest die Abweichungen (DEV) umfasst.

2. Verfahren nach Anspruch 1, wobei der Bereich (h) zumindest teilweise von den Bauelementträgern (PCB) durchlaufen wird.

3. Verfahren nach Anspruch 1 oder 2, wobei sich der Bereich (h) von maximal 40mm oberhalb einer Transportebene (h0) des Transportsystems (250) bis maximal 30mm unterhalb der Transportebene (h0) erstreckt.

4. Verfahren nach einem der vorhergehenden Ansprüche, wobei die Ist-Parameterwerte (ACT1, ACT2) weiterhin zumindest einen Messwert umfassen, der von einer der Vorrichtungen (20,30,40) bereitgestellt wird.

5. Verfahren nach einem der vorhergehenden Ansprüche, umfassend die Schritte:
- Ausgeben einer Warnmeldung (ERR), wenn die Abweichungen (DEV) einen jeweiligen Schwellwert überschreiten und/oder
- Ausgeben eines Konformitätsdatensatzes (QD), wenn die Abweichungen (DEV) einen jeweiligen Schwellwert unterschreiten.

6. Verfahren nach einem der vorhergehenden Ansprüche, wobei die Ist-Prozessparameterwerte (ACT1, ACT2) zumindest eine Restsauerstoffkonzentration im Bereich (h) und/oder eine Temperatur im Bereich (h) umfassen.

7. Verfahren nach einem der vorhergehenden Ansprüche, wobei die Ist-Prozessparameterwerte (ACT1, ACT2) zumindest teilweise durch ein Prozessparametererfassungssystem (AIO) erfasst werden, das zum Durchlaufen der Elektronikfertigungslinie (200) auf dem Transportsystem (250) ausgebildet ist.

8. Verfahren nach einem der vorhergehenden Ansprüche, wobei die Ist-Prozessparameterwerte (ACT1, ACT2) und/oder die Abweichungen (DEV) jeweils für eine definierbaren Anzahl von Baugruppen (100) vor und/oder nach deren Herstellung erfasst werden.

9. Verfahren nach einem der vorhergehenden Ansprüche, umfassend den Schritt:
- Ausgeben eines Kalibrierdatensatzes, wenn die Abweichungen (DEV) einen jeweiligen Schwellwert überschreiten.

10. Verfahren nach einem der vorhergehenden Ansprüche, wobei jeder hergestellten Baugruppe (100) ein Konformitätsdatensatz (QD) zugeordnet wird, der die Abweichungen im Bereich (h) enthält.

11. Verfahren nach einem der vorhergehenden Ansprüche, wobei die Elektronikfertigungslinie (200) und/oder eine übergeordnete Fertigungssteuerung nach einer definierbaren Anzahl an gefertigten Baugruppen (100) ein Prozessparametererfassungssystem (AIO) anfordert.

12. Verfahren zum automatisierten Kalibrieren einer Elektronikfertigungslinie (200), umfassend die Schritte:
- Betreiben einer Elektronikfertigungslinie (200) mit einem Verfahren nach einem der vorhergehenden Ansprüche und
- Einstellen eines Offsets in zumindest einer der Vorrichtungen (20,30,40) auf Basis der Abweichungen (DEV).

13. Elektronikfertigungslinie (200) zum Durchführen eines Verfahrens nach einem der vorhergehenden Ansprüche, aufweisend
- eine Vorrichtung (20) zum Aufbringen von Fügematerial auf Bauelementträger (PCB),
- eine Bestückvorrichtung (30) zum Bestücken von elektronischen Bauelementen auf die Bauelementträger (PCB),
- eine Fügevorrichtung (40) zum Fügen der elektronischen Bauelemente an die Bauelementträger (PCB),
- ein Transportsystem (250), das zum Transportieren der Bauelementträger (PCB) durch die Vorrichtungen (20, 30, 40) ausgebildet ist und
- eine Auswerteeinrichtung (210), die zum Ermitteln von Abweichungen (DEV) zwischen Ist- und Soll-Prozessparameterwerten (SET, ACT1, ACT2) ausgebildet ist.

14. Elektronikfertigungslinie (200) nach Anspruch 13, aufweisend eine Kommunikationsschnittstelle (COM1), die zum Kommunizieren mit einem Prozessparametererfassungssystem (AIO) ausgebildet ist, das zum Durchlaufen der Elektronikfertigungslinie (200) auf dem Transportsystem (250) ausgebildet ist.

15. Prozessparametererfassungssystem (AIO), das zum Durchlaufen einer Elektronikfertigungslinie (200) nach Anspruch 13 oder 14 auf dem Transportsystem (250) ausgebildet ist und zum Erfassen von Ist-Prozessparameterwerten (ACT1, ACT2), umfassend zumindest einen Parameterwert in einem begrenzten Bereich (h) um das Transportsystem (250) für das Verfahren nach einem der Ansprüche 1 bis 12 ausgebildet ist.

16. System aus einer Elektronikfertigungslinie (200) nach Anspruch 13 oder 14 und einem Prozessparametererfassungssystem (AIO) nach Anspruch 15.
